# EUROPÄISCHE PATENTANMELDUNG

(11) **EP 3 109 947 A1**
(43) Veröffentlichungstag der Anmeldung: **28.12.2016**
(21) Anmeldenummer: 16164039.6
(22) Anmeldetag: 06.04.2016
(51) Int. Cl.: H01R 12/77, H01R 12/70, H01R 12/91, H01R 13/03

(54) **ELEKTRISCHE VERBINDUNGSANORDNUNG**

(30) Priorität: 23.06.2015 DE 102015110070
(71) Anmelder: Johnson Electric S.A., 3280 Murten (CH)
(72) Erfinder: KOEPSELL, Martin, 58256 Ennepetal (DE)
(74) Vertreter: Buse, Mentzel, Ludewig Patentanwaltskanzlei

(57) **Zusammenfassung**

Die Erfindung betrifft eine abgedichtete elektrische Verbindungsanordnung zwischen einem elektrischen Bauteil (10) und einem Steckerbauteil (20). Zur flüssigkeitsdichten Abdichtung sind die freien, verformbaren Enden (14) der Leiterbahnen (12) des elektrischen Bauteils (10) und/oder die Kontaktelemente (22) des Steckerbauteils (20) zumindest bereichsweise so mit hydrophoben Oberflächen (16, 26) versehen, dass auch nach mehreren durchgeführten Steckkontaktvorgängen in der Kupplungslage und gegebenenfalls in der entkuppelten Lage der Kontaktbereich (15, 25) vollständig von hydrophoben Oberflächen (16, 26) umschlossen ist

## Beschreibung

Die Erfindung betrifft eine elektrische Verbindungsanordnung zwischen einem elektrischen Bauteil und einem Steckerbauteil. Die Erfindung betrifft des Weiteren ein elektrisches Bauteil und ein Steckerbauteil, insbesondere für den Einsatz bei der erfindungsgemäßen elektrischen Steckverbindung.

Bekannte elektrische Steckverbindungen umfassen ein Steckerbauteil, welches zur Erstellung der elektrischen Verbindung in ein entsprechendes Kupplungsteil in einen elektrischen Bauteil eingesteckt wird und zur Erzielung einer elektrischen Verbindung die Kontakte des Bauteils mit den Gegenkontakten des Steckerbauteils in Steckrichtung in Kontakt gebracht werden. Um bestehende Spalte in den Gehäusen dieser Bauteile vor eindringenden Flüssigkeiten zu schützen, sind verschiedene Abdichtungen bekannt. Beispielsweise werden Dichtringe oder andere Dichtelemente aus Elastomeren in die entsprechenden elektrischen Bauteile und Steckerbauteile eingesetzt, um die elektrische Verbindungsanordnung, nämlich die gesteckte Verbindung zwischen dem elektrischem Bauteil und dem Steckerbauteil, in der Kupplungslage abzudichten. Zur Abdichtung verwendete Dichtelemente aus verformten Elastomeren erzeugen in nachteiliger Weise große Steck- und Lösekräfte beim Herstellen der Steckverbindungen. Bei einer großen Anzahl von Steckzyklen nutzen sich die Dichtelemente ab. Diese Dichtelemente sind auch stark temperaturabhängig und somit auch die entsprechende Abdichtung. In nachteiliger Weise ist für die Dichtelemente auch ein entsprechender Platz in den Bauteilen vorzusehen. Des Weiteren sind die elektrischen Kontakte sowohl des separaten Steckerbauteils als auch des separaten elektrischen Bauteils in einer entkoppelten Lage nicht geschützt.

Des Weiteren ist aus dem Dokument DE 10 2013 009 309 A1 eine elektrische Schaltungsanordnung bekannt, welche zumindest ein flexibles Flächenelement zeigt, auf dem sich elektrische Leiterbahnen befinden. Zur Stromversorgung ist ein entsprechender Anschluss vorgesehen, um die Leiterbahnen mit entsprechenden Gegenkontakten an einem Steckerbauteil elektrisch zu verbinden. Zur Kontaktierung werden die Leiterbahnen selbst verwendet. Hierzu werden die Leiterbahnen in dem entsprechenden Anschlussbereich entsprechend freigelegt, um für eine elektrische Kontaktierung zur Verfügung zu stehen. In Kupplungslage werden an diese Leiterbahnen Gegenkontakte angelegt und damit eine elektrische Verbindung hergestellt. Bei einer solchen elektrischen Schaltungsanordnung ist es möglich, mittels des Steckerbauteils eine Vielzahl von Einsteck- und Lösezyklen vorzunehmen, jedoch ist diese elektrische Schaltungsanordnung nicht gegen das Eindringen von Flüssigkeiten geschützt.

Aus dem Gebrauchsmuster DE 20 2014 105 383 U1 werden zur Vermeidung des Eindringens von Flüssigkeit in ein Steckgehäuse eines Steckerbauteils mehrere Dichtelemente verwendet, u.a. Dichtringe aus einem hydrophoben Material, die zwischen den Kontakten des Steckerbauteils angeordnet sind. Diese Dichtmittel sind zur Abdichtung gegen ein Eindringen von Flüssigkeiten in den vom Gehäuse eingeschlossenen Raum vorgesehen. Auch hier sind die Kontakte selbst bei geöffneter Steckverbindung nicht gegen den Angriff von Flüssigkeiten geschützt.

Aufgabe der vorliegenden Erfindung ist es, eine elektrische Verbindungsanordnung zwischen einem elektrischen Bauteil und einem Steckerbauteil zur Verfügung zu stellen, die in Kupplungslage vor eindringender Flüssigkeit abgedichtet ist, aber die Kontakte der Einzelteile, nämlich des elektrischen Bauteils und des Steckerbauteils, möglichst auch so geschützt sind, dass die elektrischen Kontakte in entkuppelter Lage frei von Flüssigkeiten gehalten werden. Hierbei wird ein platzsparender Aufbau angestrebt, insbesondere soll die Abdichtung ohne zusätzliche Dichtungselemente auskommen und eine hohe Anzahl von Steck- und Lösezyklen wartungsfrei ermöglichen.

Diese Aufgabe wird mit einer elektrischen Verbindungsanordnung mit den Merkmalen des Anspruchs 1 gelöst. Vorteilhafte Ausführungen beschreiben die Unteransprüche 2 bis 5. Für eine solche elektrische Verbindungsanordnung wird insbesondere ein elektrisches Bauteil mit den Merkmalen der Ansprüche 6 bis 9 und ein Steckerbauteil mit den Merkmalen der Ansprüche 10 bis 13 eingesetzt.

Die erfindungsgemäße elektrische Verbindungsanordnung wird zwischen einem elektrischen Bauteil und einem Steckerbauteil hergestellt. Das elektrische Bauteil weist hierbei mehrere Leiterbahnen auf einem flexiblen Träger auf. Die freien Enden der Leiterbahnen sind zumindest in einem Anschlussbereich freigelegt, so dass sie jeweils Kontaktflächen bilden. Gegenkontakte sind an den Kontaktelementen eines Steckerbauteils vorgesehen. Das Steckerbauteil besitzt hierfür entsprechend der Anzahl der Leiterbahnen eine Anzahl von Kontaktelementen, die in einem Steckgehäuse untergebracht und mit elektrischen Leitungen verbunden sind. In Kupplungslage, d.h. bei eingestecktem Steckerbauteil, liegt eine elektrisch leitende Verbindung mit dem elektrischen Bauteil vor, nämlich zwischen den freien Enden der Leiterbahnen auf dem flexiblen Trägers des elektrischen Bauteils und den Kontaktelementen des Steckerbauteils. Auf diese Weise kann beispielsweise das elektrische Bauteil über die Stromleitungen des Steckerbauteils mit Strom oder auch über Datenleitungen mit Daten versorgt werden. Das elektrische Bauteil kann des Weiteren elektrische oder elektronische Bauelemente umfassen und in weiteren Anschlussbereichen können die Leiterbahnen mit weiteren elektrischen Bauteilen, wie z.B. elektrischen Schaltern oder Elektromotoren verbunden sein. Hierbei erfolgt die Kontaktierung so, dass der Kontaktbereich zwischen den Kontaktelementen des eingesteckten Steckerbauteil und den Leiterbahnen des elektrischen Bauteils von einem sich nach außen verbreiternden Spalt umgeben ist. Erfindungsgemäß sind die freien Enden der Leiterbahnen des elektrischen Bauteils und/oder die Kontaktelemente des Steckerbauteils zumindest bereichsweise so mit hydrophoben Oberflächen versehen, dass auch nach mehreren durchgeführten Steckzyklen eine sichere Abdichtung der Kontakte vorliegt. Diese Abdichtung ist in der Kupplungslage wirksam. Bei Vorsehen von hydrophoben Oberflächen sowohl am elektrischen Bauteil wie am Steckerbauteil ist die Abdichtung auch in entkoppelten Lage wirksam. Der jeweilige Kontaktbereich, nämlich der Kontaktbereich an den freien Enden der Leiterbahnen wie auch der Kontaktbereich an den Kontaktelementen des Steckerbauteils ist vollständig von hydrophoben Oberflächen umschlossen. Dies bedeutet, dass eine flüssigkeitsdichte Abdichtung sowohl in der Kupplungslage bei eingestecktem Steckerbauteil als auch eine Abdichtung und ein Schutz der Kontakte der separaten Elemente der elektrischen Verbindungsanordnung vor Flüssigkeitsangriff vorliegen.

Hydrophobe Oberflächen können durch eine entsprechende Beschichtung oder bevorzugt durch eine entsprechende Mikrostrukturierung erzielt werden, wodurch Kontaktwinkel gegenüber von Wasser > 150° möglich sind, so dass die hydrophoben Oberflächen nie nass werden. Des Weiteren ist infolge des sogenannten Moses Effekts auch der Raum über den hydrophoben Oberflächen bis zu einer gewissen Höhe frei von Flüssigkeiten, beispielsweise ist bei einem Kontaktwinkel von 150° der darüber liegende Raum in einer Höhe von 0,5 bis 1 mm frei von Wasser. Zur Erzeugung der hydrophoben Oberflächen wird vorzugsweise das Verfahren zur Strukturierung von Metalloberflächen mittels Laser verwendet, welches in "Laser-generated surface structures create extremely water repellant metals" von Chunlei Guo, University Rochester, 2015 und "Multifunctional surfaces produced by femtosecond laser pulses" Journal of Applied Physics, January 20, 2015 beschrieben wurde. Der Vorteil dieses Verfahrens besteht darin, dass die hydrophobe Eigenschaft auf die behandelte Oberfläche übertragen wird und ist dann inhärente Eigenschaft des Metalls der behandelten Leiterbahnen bzw. Kontaktelemente. Anders als bei hydrophoben Beschichtungen, die sich ggf. ablösen oder altern können. Des Weiteren können solche Beschichtungen auf den freien Enden der Leiterbahn bzw. auf den Kontaktelementen und jeweils im Kontaktbereich bei den ersten Kontaktierungen, wo diese hydrophoben Beschichtungen noch vollständig oder teilweise bestehen, elektrische Widerstände darstellen.

Sind nun solche hydrophoben Oberflächen um den Kontaktbereich, nämlich an den freien Enden der Leiterbahnen des elektrischen Bauteils und/oder an den Kontaktelementen des Steckerbauteils vorhanden, so wird insbesondere bei Vorsehen einer Mikrostrukturierung, wo die hydrophoben Oberflächen inhärente Eigenschaft der metallischen Leiterbahnen oder des metallischen Kontaktelements sind, beim Einstecken eine elektrisch leitende Verbindung zwischen den metallischen Kontakten erzielt. Auch bei einer hydrophoben Beschichtung der Oberflächen um den Kontaktbereich wird durch die dünnen hydrophoben Schichten ein Kontakt nicht verhindert. Hydrophobe Oberflächen sind sehr kratzempfindlich, so dass sich die hydrophobe Oberfläche im unmittelbaren Kontaktbereich nach mehreren Steckzyklen abnutzen, trotzdem sind beide Kontaktbereiche, nämlich der Kontaktbereich an den freien Enden der Leiterbahnen wie auch der Kontaktbereich an den Kontaktelementen des Steckerbauteils, sicher abgedichtet, da die hydrophoben Oberflächen um diesen unmittelbaren Kontaktbereich herum keiner Abnutzung unterliegen und daher wirksam bleiben. Dies ist unabhängig davon, wie groß der Kontaktbereich ist, ob es sich um eine punktuelle oder Flächenkontaktierung handelt. Sind hydrophobe Oberflächen sowohl am elektrischen Bauteil als auch am Steckerbauteil vorgesehen, so sind die Kontakte auch in der entkuppelten Lage frei von einem negativen Flüssigkeitsangriff.

Bei einer Ausführungsform können zusätzlich hydrophobe Oberflächen im Bereich solcher Spalte vorliegen, die sich zwischen dem Steckgehäuse des Steckerbauteils und der entsprechenden Aufnahme am elektrischen Bauteil ergeben. Eine solche Aufnahme am elektrischen Bauteil kann eine in Steckrichtung ausgerichtete an das Steckgehäuse des Steckerbauteils angepasste Aufnahmehülse sein, die vorzugsweise geschlossenwandig ist. In Kupplungslage verbleiben Spalte zwischen dem Steckgehäuse und der Aufnahmehülse. Zumindest eine der entsprechenden Spaltflächen kann zusätzlich mit hydrophoben Oberflächen versehen sein, wie dies von der Anmelderin in der noch unveröffentlichten DE102014110603.2 beschrieben wird. Hierbei können die hydrophoben Oberflächen entweder an den Spaltflächen in der Aufnahmehülse und/oder an den Spaltflächen am Steckgehäuse vorgesehen werden. In den meisten Fällen ist es ausreichend, eine Abdichtung mit hydrophoben Oberflächen an einem Bauteil vorzusehen. Diese zusätzlichen hydrophoben Oberflächen ersetzen die bisher bekannten Dichtringe, wobei in vorteilhafter Weise für diese hydrophoben Oberflächen kein zusätzlicher Raum in den Bauteilen vorgesehen werden muss.

Bei einer Ausführungsform werden zur Abdichtung der elektrischen Verbindungsanordnung hydrophobe Oberflächen nur am elektrischen Bauteil, vorzugsweise am flexiblen Träger, vorgesehen.

Für die neue erfindungsgemäße elektrische Verbindungsanordnung wird ein neues elektrisches Bauteil zur Verfügung gestellt, welches einen flexiblen Träger mit mehreren Leiterbahnen aufweist, wobei zumindest in einem Anschlussbereich die Enden der Leiterbahnen freigelegt sind und jeweils Kontaktflächen bilden. Hierbei sind die Enden der Leiterbahnen frei beweglich. Dies wird dadurch erreicht, dass Schlitze im flexiblen Träger vorgesehen sind, die die Enden der Leiterbahnen U-förmig umgeben. Des Weiteren ist der flexible Träger in diesem Anschlussbereich so umgebogen, dass sich die freigelegten Kontaktflächen an den Enden der Leiterbahnen nach der Faltung auf der Unterseite des flexiblen Trägers befinden und auf der gegenüberliegenden Oberseite jeweils eine elastische Stützlage für die Enden der Leiterbahnen vorgesehen ist. Diese Stützlage kann im 3D-Druck auf den flexiblen Träger aufgebracht sein. Es kann auch für jedes Ende der Leiterbahnen je ein oder ein gemeinsames metallisches Federblatt auf den flexiblen Träger befestigt sein. Ein gemeinsames Federblatt besitzt ebenfalls Schlitze korrespondierend und passend zu den Schlitzen des flexiblen Trägers. Beim Kontaktieren der freien Enden der Leiterbahnen durch einen Gegenkontakt, beispielsweise ein Kontaktelement eines Steckerbauteils, werden die im flexiblen Träger flach ausgerichteten Enden der Leiterbahnen nach oben bewegt und beulend verformt. Hierbei gewährleistet die Stützlage den notwendigen Kontaktdruck.

Ein solcher flexibler Träger kann in einem Komponententräger angeordnet sein. Bei einer vorteilhaften Ausführungsform ist insbesondere im Bereich der freien Enden der Leiterbahnen eine flüssigkeitsdichte Abdichtung mit hydrophoben Oberflächen vorgesehen, so dass ein möglicher Kontaktbereich vollständig von hydrophoben Oberflächen umschlossen ist.

Das neue Steckerbauteil, insbesondere für die neue erfindungsgemäße elektrische Verbindungsanordnung, weist eine entsprechende Anzahl von Kontaktelementen auf, die jeweils in einem Steckgehäuse aufgenommen und mit elektrischen Leitungen und/oder Datenleitungen verbunden sind. Zur flüssigkeitsdichten Abdichtung, insbesondere des Kontaktbereichs, sind am Kontaktelement hydrophobe Oberflächen zumindest um den Kontaktbereich herum vorgesehen. Da beim Steckvorgang der Kontaktbereich reibend beansprucht wird, verliert dieser Kontaktbereich teilweise oder ganz seine hydrophoben Eigenschaften. Die Umgebung um den Kontaktbereich wird beim Steckvorgang jedoch mechanisch nicht beansprucht, so dass die hydrophoben Eigenschaften um den Kontaktbereich herum unbeeinträchtigt bleiben und keine Flüssigkeit zum Kontaktbereich gelangen kann. Es ist in vorteilhafter Weise sogar so, dass beim Steckvorgang eventuell vorhandene Flüssigkeit aufgrund des sich keilförmig verengenden Spalts hin zum Kontaktbereich aus dem Bereich zwischen den Enden der Leiterbahnen und den Kontaktelementen des Steckerbauteils herausgedrängt wird.

Bei einer bevorzugten Ausführungsform ist der Kontaktbereich der Kontaktelemente jeweils durch ein solches Kontaktteil gebildet, welches die umgebene Oberfläche der Kontaktelemente überragt. Das heißt, an jedem Kontaktelement ist eine Erhebung in Form einer Noppe, eines Pins, eines abgebogenen Leiterstrangs oder in einer anderen Form vorgesehen. In der Kupplungslage kontaktiert ausschließlich dieses Kontaktteil, welches das Kontaktelement überragt, eine Leiterbahn des elektrischen Bauteils. Beim Steckvorgang wird sowohl das Kontaktteil als auch der Kontaktbereich an der Leiterbahn reibend beansprucht. Die Enden der Leiterbahnen werden bei diesem Steckvorgang in eine gebeulte Form gebracht. Diese Steckbewegung und Kontaktierung führt durch das Ausbeulen zu einer länglichen Abriebstelle auf den Leiterbahnen. Da aber auch dieser längliche Kontaktbereich auf den Leiterbahnen von hydrophoben Oberflächen, entweder an den Leiterbahnen oder aber hydrophoben Oberflächen am Kontaktelement des Steckerbauteils, umgeben und beeinflusst ist, bleiben sowohl die Kontaktbereiche der Leiterbahnen als auch das Kontaktteil frei von Flüssigkeiten.

Bei den Kontaktelementen kann es sich um Kontaktstifte eines Steckerbauteils handeln oder aber die Kontaktelemente sind als flache Leiterbahnen auf einem flexiblen Träger vorgesehen. In diesem Fall kann das überragende Kontaktteil durch Prägung erzeugt werden. Darüber hinaus ist denkbar, dass die Kontaktelemente durch Leiterstränge eines Flachbandkabels gebildet sind. Für eine elektrische Kontaktierung sind in einem möglichen Kontaktbereich die Leiterstränge von der Isolierschicht freizulegen und so zu formen, insbesondere umzubiegen, dass im Kontaktbereich vorstehende Kontaktteile erzeugt werden. Die umgebogenen Leiterstränge bilden eine zweifach gekrümmte Oberfläche, die auch bei anderen Kontaktteilen vorgesehen werden kann. Beim Steckvorgang kommt diese gekrümmte Oberfläche eines solchen Kontaktteils punktförmig mit der bei Steckbeginn ebenen Leiterbahn in Kontakt. Diese punktförmige Berührung ist optimal für elektrische Kontaktpaare und ist unbeeinflusst von Winkelabweichungen.

Durch die Erfindung liegt eine elektrische Verbindungsanordnung vor, die flüssigkeitsdicht ist und umfasst eine Abdichtung, die von der Temperatur unabhängig ist. Die Steck- und Abzugskräfte sind niedrig und es ist eine Vielzahl von Steckzyklen möglich. Bei geöffneter Steckverbindung kann vorgesehen werden, dass die elektrischen Kontakte sowohl am elektrischen Bauteil als auch am Steckerbauteil frei von Flüssigkeiten bleiben, wodurch die spannungsführenden Teile gegen Kurzschluss geschützt sind. So geschützte Teile können auch unter Wasser verwendet werden, d.h. eine solche Steckverbindung kann unter Wasser geschlossen und geöffnet werden. Hierbei wird die Abdichtung vorzugsweise durch inhärente Eigenschaften der metallischen Kontakte erzielt. Es werden keine zusätzlichen, raumfordernden Dichtelemente benötigt. Zusätzliche hydrophobe Oberflächen im Bereich zur Gehäuseabdichtung werden ebenfalls berührungsfrei und ohne zusätzlichen Bauraum realisiert. Darüber hinaus ist es von Vorteil, dass eine Abdichtung am Stecker des Steckerbauteils auch nachträglich vorgesehen werden kann, d.h. auch nachträglich kann ein solches Steckerbauteil flüssigkeitsdicht ausgerüstet werden. Dies kann ein Steckerbauteil für eine elektrische Verbindung wie auch für eine Datenverbindung sein, beispielsweise ein USB-Stecker.

Die elektrische Verbindungsanordnung, die neuen elektrischen Bauteile, die neuen Steckerbauteile sowie das Verdrängen von vorhandener Flüssigkeit aus der Kontaktzone beim Steckvorgang werden nachfolgend anhand von Ausführungsbeispielen und der Zeichnung näher erklärt.

Die Zeichnung zeigt:
- Fig. 1: eine perspektivische Ansicht eines neuen elektrischen Bauteils,
- Fig. 2a: einen flachen flexiblen Träger für das elektrischen Bauteil von Fig. 1,
- Fig. 2b: den gefalteten flexiblen Träger von Fig. 2a,
- Fig. 2c: den gefalteten flexiblen Träger von Fig. 2b mit Stützlage,
- Fig. 3a: eine Schnittansicht der elektrischen Verbindungsanordnung mit dem elektrischen Bauteil von Fig. 1,
- Fig. 3b: einen vergrößerten Ausschnitt von Fig. 3a,
- Fig. 3c: eine perspektivische Teilansicht des Kontaktelementes,
- Fig. 3d: eine perspektivische Teilansicht des flexiblen Träges in gestecktem Zustand ohne Gegenkontakt,
- Fig. 4: einen Teil einer Schnittansicht einer weiteren elektrischen Verbindungsanordnung,
- Fig. 5: eine perspektivische Teilansicht des flexiblen Trägers von Fig. 4,
- Fig. 6: eine perspektivische Ansicht eines weiteren elektrischen Bauteils mit Steckerbauteil in Kupplungslage,
- Fig. 7a: eine Schnittansicht der elektrischen Verbindungsanordnung mit dem elektrischen Bauteil von Fig. 6,
- Fig. 7b: einen vergrößerten Ausschnitt des elektrischen Bauteils in entkuppelter Lage,
- Fig. 7c: einen vergrößerten Ausschnitt von Fig. 7a,
- Fig. 7d: eine perspektivische Teilansicht von Fig. 6,
- Fig. 8: eine Teilansicht von einer weiteren elektrischen Verbindungsanordnung.

Die Zeichnung umfasst mehrere Ausführungsbeispiele. Gleiche Elemente sind mit den gleichen Bezugszeichen versehen, auch wenn sie in den unterschiedlichen Beispielen abweichende Merkmale besitzen.

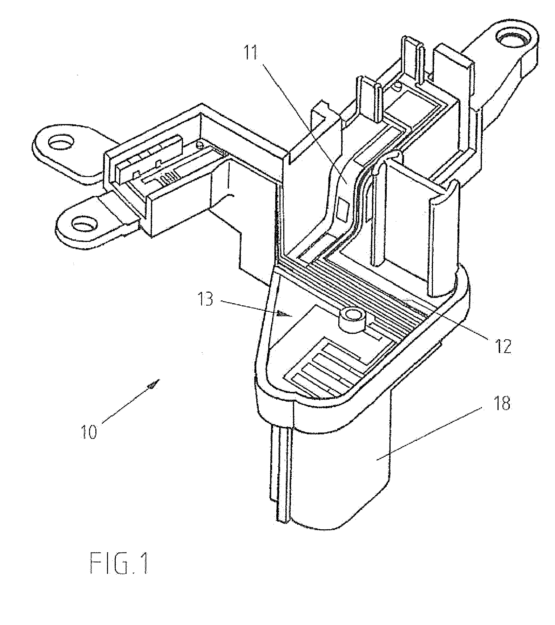

Die Fig. 1 zeigt eine Ausführungsform eines erfindungsgemäßen elektrischen Bauteils 10, in diesem Fall einen Komponententräger, mit einem flexiblen Trägerelement 11, welches Leiterbahnen 12 aufweist, die in unterschiedlichen Anschlussbereichen mit weiteren elektrischen Bauteilen verbunden werden können, beispielsweise mit einem Schalter, mit einem Motor und im Anschlussbereich 13 mit einem Steckerbauteil 20. Das Steckerbauteil 20 wird von unten in das elektrischen Bauteils 10 eingesteckt. Zur Aufnahme und mechanischen Fixierung des Steckerbauteils 20 ist im Anschlussbereich 13 eine Aufnahmehülse 18 vorgesehen.

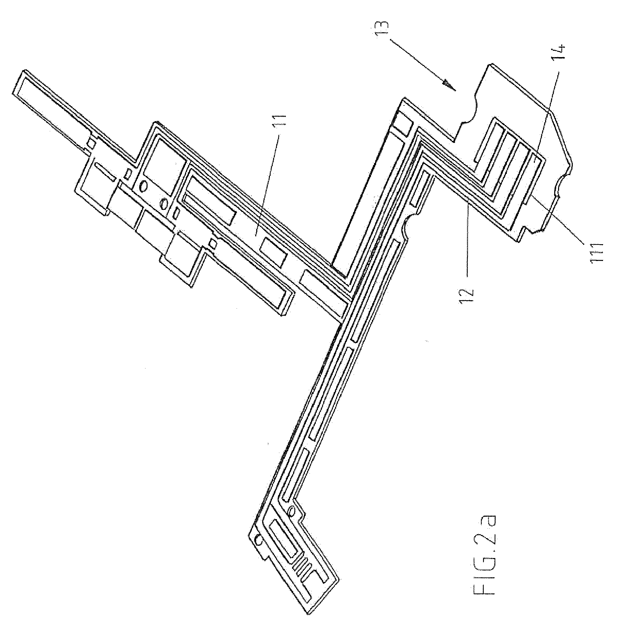

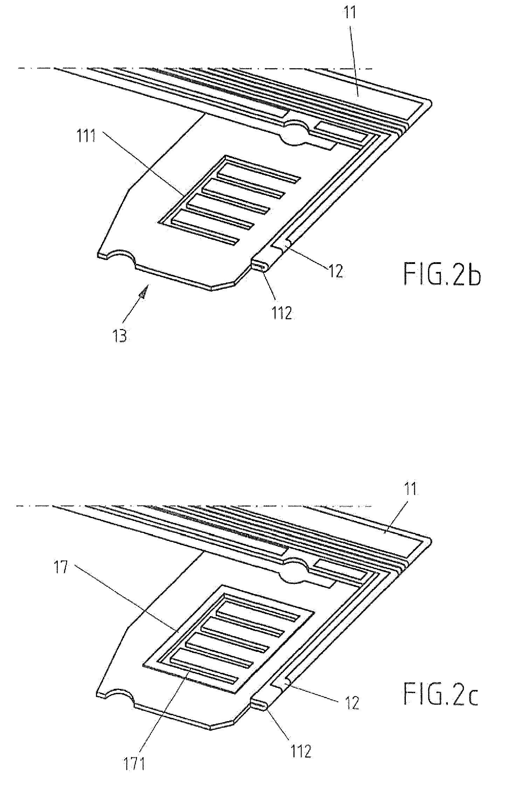

In der Fig. 2a ist der in Fig. 1 verwendete flexible Träger 11 noch in seiner flachen Form dargestellt, d.h. vor der Umformung und Montage im Komponententräger. Dieser flexible Träger 11 besteht aus mindestens einer nichtleitenden Schicht auf Kunststoffbasis, auf der eine weitere Schicht in Form von Leiterbahnen 12 vorgesehen ist. In den jeweiligen Anschlussbereichen, beispielsweise im Anschlussbereich 13 für das Steckerbauteil 20, sind die Leiterbahnen 12 frei zugänglich. Außerhalb des Anschlussbereiches 13 und der weiteren Anschlussbereiche können die Leiterbahnen 12 von einer weiteren nichtleitenden isolierenden Schicht abgedeckt sein, was den Figuren nicht zu entnehmen ist. Darüber hinaus wird in der Fig. 2a deutlich, dass die Enden 14 der Leiterbahnen 12 durch Schlitze 111 im Träger 11 freibeweglich ausgestaltet sind. Diese Schlitze 111 umgeben jedes Ende 14 jeder Leiterbahn 12 im Anschlussbereich 13 U-förmig. Dies wird noch besser deutlich in der Fig. 2b. Diese Fig. 2b zeigt nur den Anschlussbereich 13 des flexiblen Trägers 11 von Fig. 2a und zwar nach der Umformung, d.h. Anpassung des flexiblen Trägers 11 an die Form des in Fig. 1 gezeigten Komponententrägers. Zu diesem Umformungsschritt gehört auch eine Faltung des flexiblen Trägers 11 im Anschlussbereich 13. Auf diese Weise gelangen die in Fig. 2a sichtbaren Enden 14 der Leiterbahnen 12 im Anschlussbereich 13 aufgrund der Faltung 112 auf die Rückseite des flexiblen Trägers 11. In Fig. 2b ist die umgebogene Rückseite des flexiblen Trägers 11 im Anschlussbereich 13, insbesondere die Schlitze 111 im flexiblen Träger 11 sichtbar. Aufgrund der flexiblen Ausbildung des Trägers 11 ist eine solche Faltung 112 in einfacher Weise und raumsparend möglich. Zusätzlich wird auf der Rückseite des Trägers 11, welche sich im Anschlussbereich 13 an der Oberseite befindet, eine Stützlage 17 im Bereich der Enden 14 der Leiterbahnen 12 vorgesehen. Im Beispiel der Fig. 2c ist diese Stützlage 17 eine metallische Blattfeder, die an die Form und Größe der Enden 14 der Leiterbahnen 12 in diesem Anschlussbereich 13 angepasst ist. Diese als Stützlage 17 vorgesehene Blattfeder weist ebenfalls Schlitze 171 auf, die mit den Schlitzen 111 im flexiblen Träger 11 korrespondieren und die Beweglichkeit der Enden 14 der Leiterbahnen 12 gewährleisten. Da der aus Kunststoff bestehende flexible Träger 11 selbst nur eine geringe Abstützung gewährleistet, sind die Enden 14 der Leiterbahnen 12 in diesem Anschlussbereich 13 durch eine solche Stützlage 17 unterstützt, welche bei einer Kontaktierung der Leiterbahnen 12 für einen ausreichenden Kontaktdruck sorgt. Neben einer Blattfeder kommen auch andere elastische Materialien in Frage.

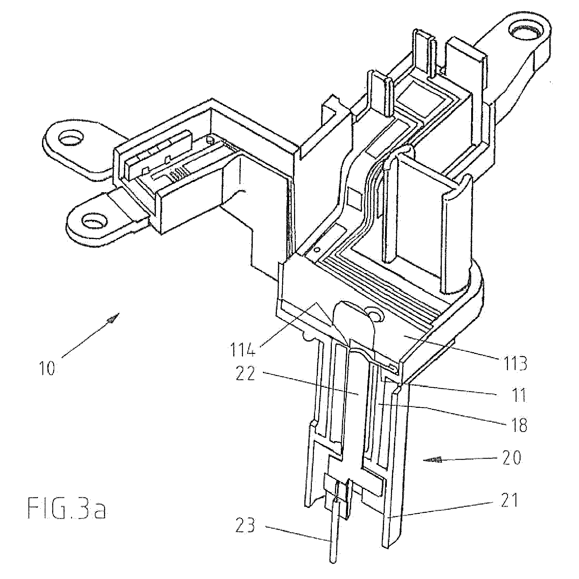

Bei einem Steckkontakt, nämlich einem Einstecken eines Steckerbauteils 20 von unten in die Aufnahmehülse 18 im Anschlussbereich 13, siehe Fig. 1, werden die noch flachen Enden 14 der Leiterbahnen 12 durch die von unten kontaktierenden Kontaktelemente 22 des Steckerbauteils 20 nach oben durchgebogen. Die elektrische Verbindungsanordnung in Kupplungslage ist in Fig. 3a gezeigt, nämlich das elektrische Bauteil 10 verbunden mit dem Steckerbauteil 20. Dieses Steckerbauteil 20 umfasst eine Anzahl von Kontaktelementen 22, nämlich eine zur Anzahl der Enden 14 der Leiterbahn 12 korrespondierenden Anzahl. Diese Kontaktelemente 22 sind in einem Steckgehäuse 21 untergebracht und mit elektrischen Leitungen 23 verbunden. Der flexible Träger 11 ist im Anschlussbereich 13 mit einer Abdeckung 113 abgedeckt. Diese Abdeckung 113 dient bereichsweise insbesondere auch als Gegenlage 114 für die freien Enden 14 der Leiterbahnen 12 des flexiblen Trägers 11 beim Steckvorgang.

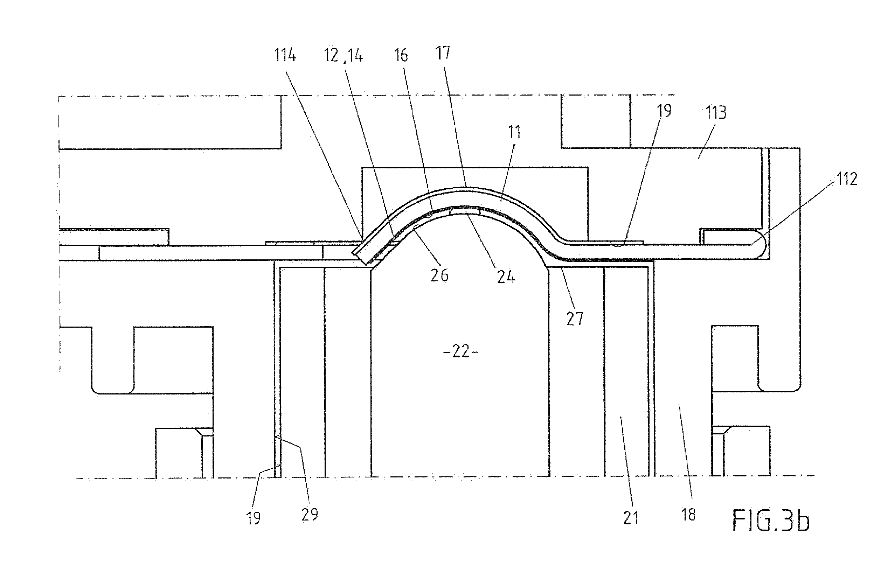

Die Fig. 3b zeigt eine vergrößerte Ansicht der Kupplungslage. Das Steckerbauteil 20 ist von unten, d.h. in Steckrichtung, in das elektrische Bauteil 10 eingesteckt. Das Steckgehäuse 21 umfasst die Aufnahmehülse 18 des elektrischen Bauteils 10. Das Steckerbauteil 20 kontaktiert in dieser Kupplungslage mit seinen Kontaktelementen 22 die Enden 14 der Leiterbahnen 12 des elektrischen Bauteils 10. Das stiftartige Kontaktelement 22 verformt beim Einstecken den flachen flexiblen Träger 11 mit den Leiterbahnen 12, wobei jedes Ende 14 der Leiterbahnen 12 nach oben durchgebogen wird, was durch die freie Beweglichkeit der Enden 14 der Leiterbahnen 12 möglich wird. In der Abdeckung 113 ist für die ausgebeulten Enden 14 der Leiterbahnen 12 eine Gegenlage 114 und eine entsprechend große Ausnehmung vorgesehen. Beim Steckvorgang wird durch die elastische Stützlage 17 der vom Kontaktelement 22 ausgeübte Kontaktdruck auf die Leiterbahnen 12 gehalten.

In diesem Ausführungsbeispiel kontaktiert das stiftartige Kontaktelement 22 des Steckerbauteils 20 mit seinem Kontaktteil 24 die Leiterbahn 12 des elektrischen Bauteils 10. Dieses Kontaktteil 24 ist eine Erhebung auf dem Kontaktelement 22, d.h. es überragt die Oberfläche des Kontaktelementes 22 in Steckrichtung. Die Oberfläche des Kontaktteils 24 stellt den Kontaktbereich des Kontaktelementes 22 dar.

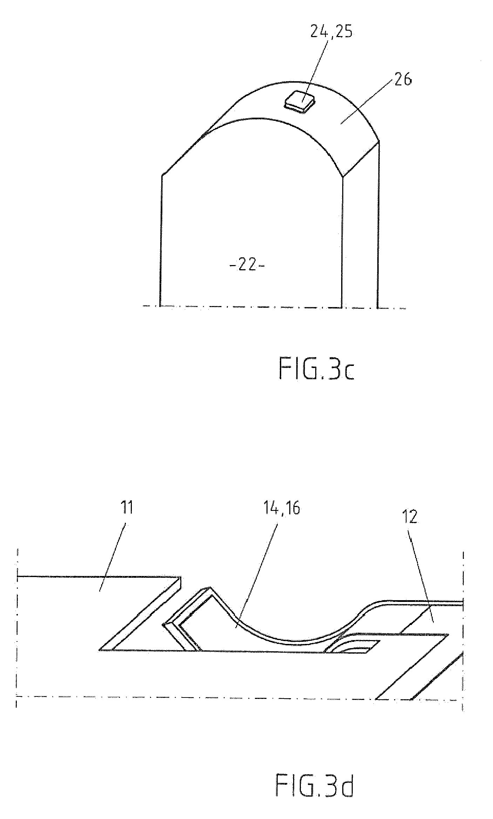

In erfindungsgemäßer Weise sind die Enden 14 der Leiterbahnen 12 mit einer hydrophoben Oberfläche 16 versehen. In gleicher Weise weist in diesem Beispiel auch die in Steckrichtung zeigende Oberfläche des Kontaktelementes 22 eine hydrophobe Oberfläche 26 auf. Diese hydrophoben Oberfläche 16, 26 wurden durch eine Laserstrukturierung erzielt, d.h. die metallischen Oberflächen der Leiterbahnen 12 bzw. des Kupplungselementes 22 besitzen durch diese besondere Mikrostrukturierung selbst diese hydrophoben Eigenschaften. Bei einem Steckvorgang nähern sich die Kontaktelemente 22 an die Leiterbahnen 12 an. Es wird jeweils ein enger Spalt gebildet , der an der Kontaktstelle des Kontaktteils 24 am engsten ist, dabei wird eventuell vorhandene Flüssigkeit aufgrund der hydrophoben Oberflächen 16, 26 von innen vom Kontaktbereich 15, 25 weg nach außen verdrängt Bei einem solchen Steckvorgang wird der Kontaktbereich 25 eines Kontaktelementes 22 und der gegenüberliegenden Kontaktbereich 15 an den Leiterbahnen 12 und damit die hydrophoben Oberflächen 16, 26 in diesen Bereichen durch Reibung beansprucht. Nach mehreren Steckkontakten verlieren diese Kontaktbereiche 15, 25 teilweise oder ganz ihre hydrophoben Eigenschaften. In der Fig. 3c ist das Kontaktelement 22 mit seinem abragenden Kontaktteil 24 vor dem ersten Steckkontakt zu sehen. Eine hydrophobe Oberfläche 26 ist auch auf dem Kontaktteil 24 noch vollständig erhalten. Nach mehreren Steckkontakten kann die hydrophobe Eigenschaft der Oberfläche auf dem Kontaktteil 24 abgenutzt sein. Dieser Fig. 3c ist des Weiteren zu entnehmen, dass der Kontaktbereich 25 des Steckerbauteils 20, der in diesem Fall durch die Oberfläche des Kontaktteils 24 gebildet ist, auch nach dem Verlust der hydrophoben Eigenschaften in diesem Bereich weiterhin vollständig von einer hydrophoben Oberfläche 26 umgeben ist, da dieses Kontaktteil 24 eine Erhebung darstellt und die umgebende hydrophobe Oberfläche 26 am Kontaktelement 22 beim Steckkontakt mechanisch nicht beansprucht wird. Um das Kontaktelement 24 herum bleibt die hydrophobe Eigenschaft durch die umgebende hydrophobe Oberfläche 26 erhalten. Auch nach einer Vielzahl von Steckkontakten kann weiterhin keine Flüssigkeit zur Kontaktstelle 25 gelangen.

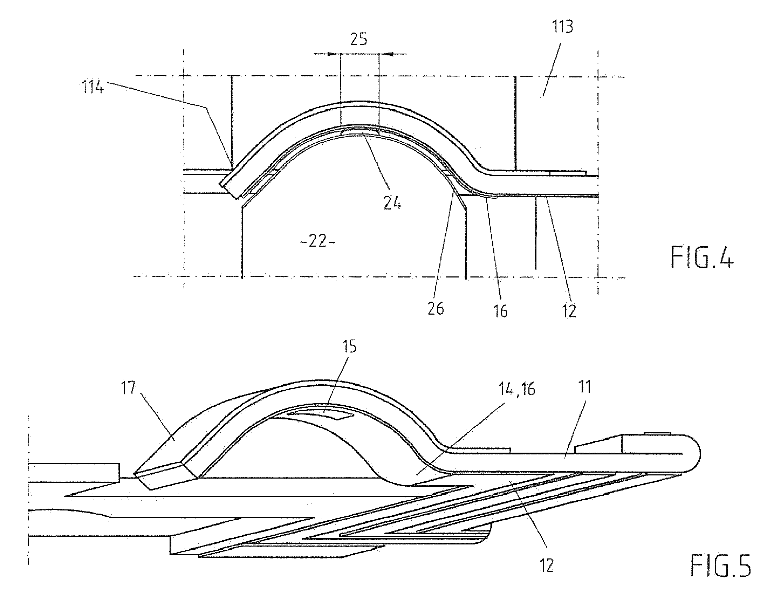

In Fig. 3d ist die einem Kontaktteil 24 gegenüberliegende Seite, d.h. ein Ende 14 der Leiterbahnen 12 ohne die Gegenlage 114, die die gebeulte Form verursacht, gezeigt. In diesem Beispiel ist an den Enden 14 der Leiterbahnen 12 ebenfalls eine hydrophobe Oberfläche 16 vorgesehen. Beim Einsteckvorgang werden die Enden 14 der Leiterbahnen 12 in Steckrichtung gebeult, d.h. das Kontaktteil 24 reibt in einer Längsbewegung an der Leiterbahn 12 entlang. Infolgedessen ergibt sich an den hydrophoben Oberflächen 16 der Enden 14 der Leiterbahnen 12 eine längliche Abriebstelle, siehe beispielsweise Fig. 5. Aber auch in diesem Fall ist eine solche längliche Abriebstelle weiterhin vollständig von einer hydrophoben Oberfläche 16 umgeben und die Kontaktbereiche 15 auf den Leiterbahnen 12 vor Flüssigkeitskontakt geschützt.

Ein weiteres Ausführungsbeispiel zeigt die Fig. 4. Hier ist von der elektrischen Verbindungsanordnung ausschließlich eine Teilschnittansicht im Anschlussbereich 13 gezeigt. Die Leiterbahnen 12 sind in diesem Beispiel mit einer hydrophoben Oberfläche 16 beschichtet. In gleicher Weise weist das Kontaktelement 22 auf seiner in Steckrichtung zeigenden Oberfläche eine durch Beschichtung erzeugte hydrophobe Oberfläche 26 auf. Auch in diesem Fall ist ein Kontaktteil 24 vorgesehen, das sich von der Oberfläche des Kontaktelementes 22 erhebt und damit mit seiner Oberfläche allein den Kontaktbereich 25 bildet. Auf der gegenüberliegenden Seite haben wir den länglichen Kontaktbereich 15, siehe Fig. 5, der sich aufgrund der Bewegung des Kontaktteiles 24 entlang des Endes 14 der Leiterbahn 12 beim Ausbeulen ergibt. Nach mehreren Steckkontakten wird dieser Kontaktbereich 15 sichtbar, da in diesem Bereich die Beschichtung der hydrophoben Oberfläche 16 abgerieben wird. Aber auch nach einer Vielzahl von Steckkontakten ist sowohl der Kontaktbereich 15 am elektrischen Bauteil 10 als auch der Kontaktbereich 25 am Steckerbauteil 20 von einer ausreichend großen, hydrophoben Oberfläche 16, 26 umgeben. Den ausreichenden Kontaktdruck gewährleistet auch in diesem Beispiel eine Blattfeder als Stützlage 17.

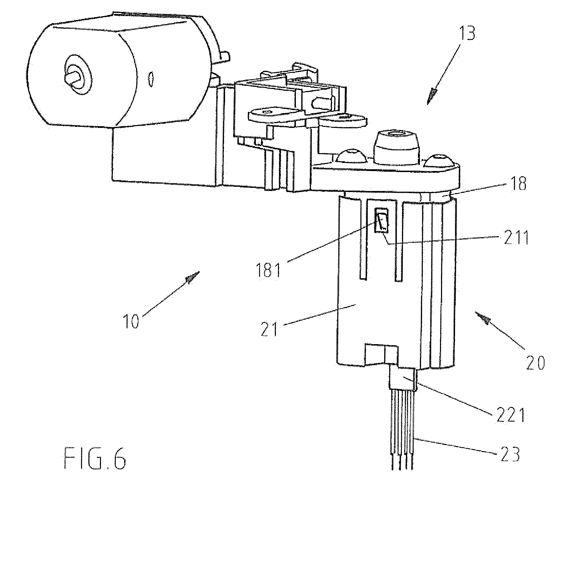

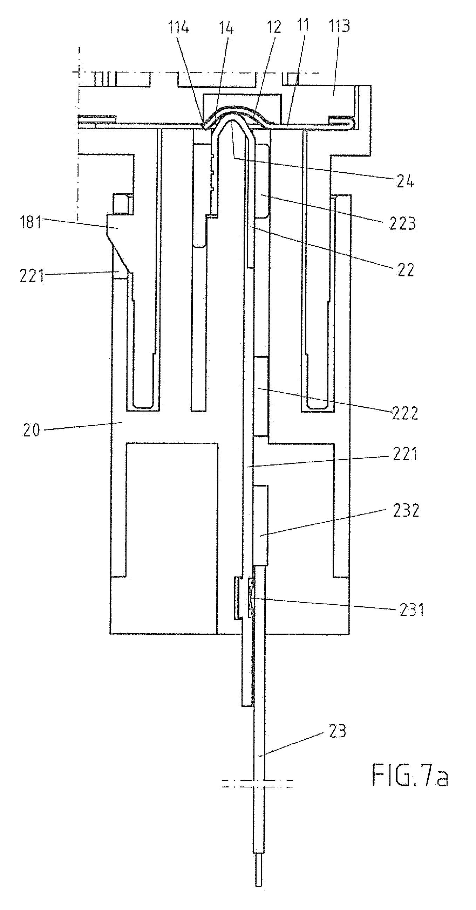

Die Fig. 6 zeigt eine weitere Ausführungsform einer elektrischen Verbindungsanordnung mit dem elektrischen Bauteil 10 gemäß Fig. 1 und mit einem weiteren eingestecktem Steckerbauteil 20. Dieses neue Steckerbauteil 20 ist über eine Klemmverbindung am elektrischen Bauteil 10 gehalten. Hierzu ist an der Aufnahmehülse 18 des elektrischen Bauteils ein Klemmarm 181 vorgesehen, der in eine entsprechende Klemmausnehmung am Steckgehäuse 21 des Steckerbauteils 20 eingreift und die Stecklage des Steckerbauteils 20 am elektrischen Bauteil 10 sichert. Von außen führt ein Kabelbaum mit den Leitungen 23 in das Steckgehäuse 21 des Steckerbauteils 20. Die Leitungen 23 sind mit einem Flachkabel 221 verbunden, wie besser aus Fig. 7a zu ersehen ist. Die Leitungen 23 und das Flachkabel 221 sind elektrisch über einen Kabelverbinder 232 miteinander verbunden. Das Flachkabel 221 wird über eine Elastomer-Dichtung 222 im Steckgehäuse 21 gehalten. Die Elastomer-Dichtung 222 ist auf das Flachbandkabel 221 geklebt und wird bei der Montage im Steckerbauteil 20 mediendicht komprimiert. Das Flachkabel 221 wird einschließlich seiner freigelegten Enden, die im Steckerbauteil 20 durch einen Kabelanschluss 223 gegen Herausziehen gesichert sind, gespannt und in gespannten Zustand mit dem Steckerbauteil 20 durch Prägen 231 formschlüssig verbunden. Die elektrische Verbindung bleibt unbeeinträchtigt, weil sie in dem davor liegenden Abschnitt mit einem Kabelverbinder 232 erfolgt. An der Stirnseite des Steckerbauteils 20 ist das Flachbandkabel 221 von der Isolierung freigelegt und stellt ein Kontaktelement 22 dar. Das Flachbandkabel 221 ist in diesem vorderen Bereich zu einer Spitze umgebogen, dem Kontaktteil 24, mit welchem das Steckerbauteil 20 die Leiterbahnen 12 im Bereich der freien Enden 14 kontaktiert. Das abgebogene Ende des Flachbandkabels 221 ist im vorderen Bereich über einen Kabelanschluss 223 sicher im Steckgehäuse 21 gehalten.

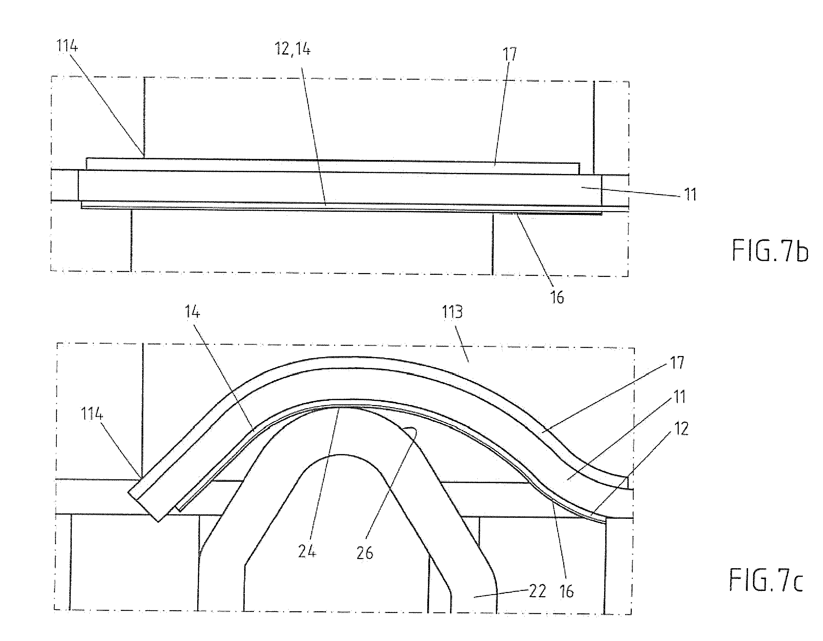

Bevor ein solches Steckerbauteil 20 in das elektrische Bauteil 10 eingesteckt wird, liegen die freien Enden 14 der Leiterbahnen 12 des flexiblen Trägers 11 noch flach im elektrischen Bauteil 10, wie der Fig. 7b zu entnehmen ist. Auf der einen Seite des flexiblen Trägers 1 list die Stützlage 17 vorgesehen und auf der anderen Seite die Leiterbahnen 12, die von dem Kontaktteil 24 des Kontaktelementes 22 des Steckerbauteils 20 kontaktiert werden. Diese Kontaktseite ist mit einer hydrophoben Oberfläche 16 versehen. Beim Steckvorgang werden die umgebogenen Leiterstränge des Fachkabels 221, die das Kontaktelement 22 bilden, an die freien Enden 14 der Leiterbahnen 12 des flexiblen Trägers 11 gedrückt. Hierbei finden die freien Enden 14 des flexiblen Trägers 11 eine Gegenlage 114 an der Abdeckung 113. Beim Ausbeulen des flexiblen Trägers 11 gleitet das Kontaktteil 14 an der Leiterbahn 12 bis in die Kupplungslage. In der vergrößerten Darstellung wird die Kupplungslage in Fig. 7c deutlich. Die Kontaktteile 24, welche jeweils durch zwei gekrümmte Oberflächen des freigelegten Flachbandkabels 221 gebildet sind, nähern sich an die Leiterbahnen 12 an und treten punktförmig mit diesen in Kontakt. Neben der optimalen punktförmigen Berührung zwischen den Kontaktteilen 24 und den freien Enden 14 der Leiterbahnen 12 ist der Kontaktbereich auch abgedichtet. Da in dieser Ausführungsform zum einen die Enden 14 der Leiterbahn mit einer hydrophoben Oberfläche 16 und das Kontaktelement 22 im gesamten abgebogenen Bereich mit einer hydrophoben Oberfläche 26 versehen ist. Zwar kann nach mehreren Steckkontakten die hydrophobe Eigenschaft der Oberflächen am Kontaktteil 24 abgenutzt sein. Aber auch in diesem Fall ist das Kontaktteil 24 vollständig von einer hydrophoben Oberfläche 26 des Kontaktelementes 22 umgeben, da das Kontaktteil 24 eine Erhebung darstellt und die umgebene hydrophobe Oberfläche 26 am Kontaktelement 22 beim Steckkontakt mechanisch nicht beansprucht wird. Somit wird in gleicher Weise, wie bei der Ausführung gemäß Fig. 3a, auch bei dieser Anordnung bei einem erneuten Einstecken, d.h. beim Annähern der Kontakteelemente 22 an die Leiterbahnen 12, der Abstand bis zur Kontaktierung verringert und eventuell vorhandene Flüssigkeit aufgrund des sich keilförmig verengenden Spalts hin zum Kontaktbereich durch die hydrophoben Oberflächen 16, 26, die den Spalt bilden, nach außen verdrängt.

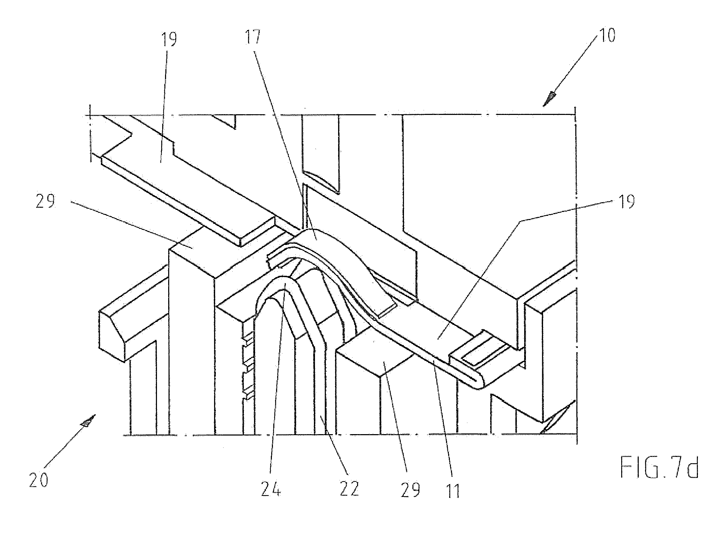

Neben den hydrophoben Oberflächen 16, 26, die den jeweiligen Kontaktbereich umgeben, können zur Abdichtung des elektrischen Bauteils 10 weitere hydrophobe Oberflächen 19 und zur Abdichtung des Steckerbauteils 20 weitere Oberflächen 29, gezeigt in Fig. 7d, vorgesehen werden. In vorteilhafterweise benötigen diese Abdichtungen gegenüber Abdichtungen mit Dichtringen keinen zusätzlichen Raum.

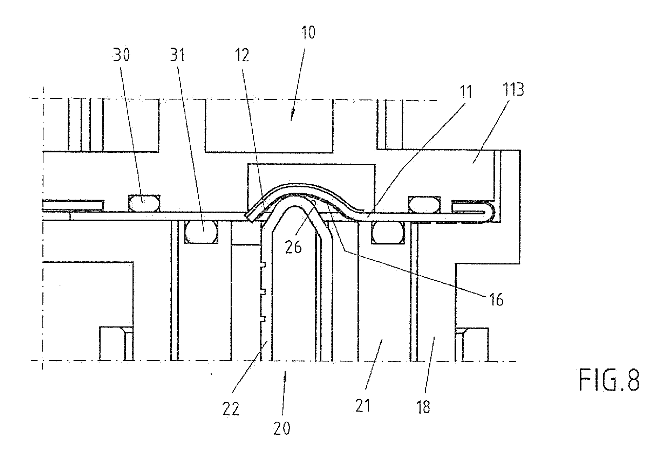

Fig. 8 zeigt eine elektrische Verbindungsanordnung, bei der sowohl am Steckerbauteil 20 ein Dichtring 31 und am elektrischen Bauteil 10 ein Dichtring 30 vorgesehen sind. Auch bei diesen bekannten elektrischen Verbindungsanordnungen mit Dichtringen 30, 31 kann der Kontaktbereich frei von Flüssigkeiten gehalten werden, in dem nachträglich hydrophobe Oberflächen 16 an den Leiterbahnen 12 des flexiblen Trägers 11 und hydrophobe Oberflächen 26 am Kontaktelement 22 vorgesehen werden, in diesem Fall vorzugsweise durch eine hydrophobe Beschichtung.

Die Zeichnungen zeigen nur ausgewählte Ausführungsbeispiele. Die Erfindung ist nicht auf die Beispiele beschränkt. So ist es beispielsweise auch möglich, nur eine hydrophobe Oberfläche 16 oder 26 vorzusehen, da beim Steckvorgang eventuell vorhandene Flüssigkeit allein durch eine hydrophobe Oberfläche 16 oder 26 aus dem engen Spalt gedrängt werden kann. Eine solche hydrophobe Oberfläche 16 kann allein am elektrischen Bauteil 10, d.h. an den Leiterbahnen 12 des flexiblen Trägers 11 vorgesehen sein oder allein am Steckerbauteil 20, d.h. an der Oberfläche des Kupplungselementes 22. Die Erfindung ermöglicht damit auf einfache Weise ein Abdichten der Kupplungslage einer elektrischen Verbindungsanordnung.

Darüber hinaus können auch die Einzelteile, nämlich das elektrische Bauteil 10 bzw. das Steckerbauteil 20 in entkuppelter Lage gegen Beeinträchtigung durch Flüssigkeit, ggf. durch zusätzliche hydrophobe Oberflächen, geschützt sein. Fig. 3b zeigt beispielsweise das Vorsehen von hydrophoben Oberflächen 19, 29, nämlich hydrophobe Oberflächen 19 an der Aufnahmehülse 18 des elektrischen Bauteils 10 und hydrophobe Oberflächen 29 am Steckgehäuse 21 des Steckerbauteils 20. Beim Steckvorgang ergibt sich ein Spalt zwischen dem Steckgehäuse 21 und der Aufnahmehülse 18. Das Eindringen von Flüssigkeiten durch diesen Spalt in das jeweilige Gehäuseinnere wird durch die Oberfläche 19 und/oder die hydrophobe Oberfläche 29 wirksam verhindert. Auch auf das Vorsehen von Dichtringen im Bereich der Frontseite 27 des Steckerbauteils 20 kann verzichtet werden, wenn die hydrophobe Oberflächen 29 bis in diesen Bereich reichen. Durch hydrophobe Oberflächen 26 und 29 ist ein Steckerbauteil 20 auch in entkuppelter Lage geschützt. Zur Flüssigkeitsabdichtung einer elektrischen Verbindungsanordnung wäre es ausreichend, wenn ausschließlich das elektrische Bauteil 10 entsprechende hydrophobe Oberflächen 16, 19 aufweist. Dies kann neben der hydrophoben Oberfläche 16 an den Enden 14 der Leiterbahnen 12 eine zusätzliche hydrophobe Oberfläche 19 um den Anschlussbereich 13 herum sein wie in Fig. 3b gezeigt. Diese zusätzlichen hydrophoben Oberflächen 19 werden vorzugsweise am flexiblen Träger vorgesehen, da eine Abdeckung 113 allein den Anschlussbereich 13 nicht vor einem Flüssigkeitseintritt schützen kann.

In vorteilhafter Weise können auch bestehende Konstruktionen nachträglich auf die beschriebene Weise abgedichtet werden.

### Bezugszeichenliste

- 10: elektrisches Bauteil
- 11: flexible Träger
- 111: Schlitze
- 112: Faltung
- 113: Abdeckung
- 114: Gegenlage
- 12: Leiterbahn
- 13: Anschlussbereich (Stecker)
- 14: freie Ende von 12
- 15: Kontaktbereich
- 16: hydrophobe Oberfläche
- 17: Stützlage
- 171: Schlitze
- 18: Aufnahmehülse
- 181: Klemmarm
- 19: hydrophobe Oberfläche
- 20: Steckverbinder
- 21: Steckgehäuse
- 211: Klemmausnehmung
- 22: Kontaktelement
- 221: Flachbandkabel
- 222: Elastomer-Dichtung (auf Flachbandkabel geklebt)
- 223: Kabelanschluss
- 23: elektrische Leitung
- 231: Prägung
- 232: Kabelverbinder
- 24: Kontaktteil, Pin
- 25: Kontaktbereich
- 26: hydrophobe Oberfläche
- 27: Frontseite
- 29: hydrophobe Oberfläche
- 30, 31: Dichtring

## Patentansprüche

1. Elektrische Verbindungsanordnung zwischen einem elektrischen Bauteil (10) und einem Steckerbauteil (20),
- wobei das elektrische Bauteil (10) auf einem flexiblen Träger (11) mehrere Leiterbahnen (12) aufweist, deren freie Enden (14) in einem Anschlussbereich (13) freigelegt sind und jeweils Kontaktflächen bilden,
- wobei der Steckerbauteil (20) eine den Leiterbahnen (12) zugeordnete Anzahl von Gegenkontakten an Kontaktelementen (22) besitzt, die jeweils in einem Steckgehäuse (21) aufgenommen und mit elektrischen Leitungen (23) verbunden sind,
- wobei in Kupplungslage eine elektrisch leitende Verbindung zwischen einem Kontaktbereich (15) der freien Enden (14) der Leiterbahnen (12) des elektrischen Bauteils (10) und einem Kontaktbereich (25) der Kontaktelemente (22) des Steckerbauteils (20) vorliegt,
**dadurch gekennzeichnet, dass**
- zur flüssigkeitsdichten Abdichtung die freien Enden (14) der Leiterbahnen (12) des elektrischen Bauteils (10) und/oder die Kontaktelemente (22) des Steckerbauteils (20) zumindest bereichsweise so mit hydrophoben Oberflächen (16, 26) versehen sind,
- dass auch nach mehreren durchgeführten Steckkontaktvorgängen in der Kupplungslage der Kontaktbereich (15, 25) vollständig von hydrophoben Oberflächen (16, 26) umschlossen ist und
- auch in der entkuppelten Lage der Kontaktbereich (15, 25) der Leiterbahnen (12) und/oder der Kontaktelemente (22) vollständig von einer hydrophoben Oberfläche (16, 26) umschlossen ist.

2. Elektrische Verbindungsanordnung gemäß Anspruch 1, **dadurch gekennzeichnet, dass** zur mechanischen Steckverbindung das elektrischen Bauteil (10) für die Aufnahme des Steckgehäuses (21) des Steckerbauteils (20) einen in Steckrichtung ausgerichtete, korrespondierende Aufnahmehülse (18) besitzt und zur Abdichtung der Spalte zwischen des Steckgehäuses (21) und/oder der Aufnahmehülse (18) zusätzlich Flächen im Bereich der Spalte mit hydrophoben Oberflächen (19, 29) versehen sind.

3. Elektrische Verbindungsanordnung gemäß Anspruch 1, **dadurch gekennzeichnet, dass** zur Abdichtung nur hydrophobe Oberflächen (16, 26) am flexiblen Träger des elektrischen Bauteils (10) vorgesehen sind.

4. Elektrische Verbindungsanordnung gemäß einem der Ansprüche 1 bis 3, **dadurch gekennzeichnet, dass** die hydrophoben Oberflächen (16, 26) aus dem metallischen Material der Leiterbahnen (12) und/ oder aus dem metallischen Material des Kontaktelementes (22) durch Laserstrukturierung erzeugt wurden.

5. Elektrische Verbindungsanordnung gemäß einem der Ansprüche 1 bis 4, **dadurch gekennzeichnet, dass** in Kupplungslage der elektrische Kontakt jeweils zwischen einem gebeulten freien Ende (14) der Leiterbahnen (12) des flexiblen Trägers (11) des elektrischen Bauteils (10) und einem aus der Oberfläche der Kontaktelemente (22) abragenden Kontaktteils (24) des Steckerbauteils (20) besteht und der Kontaktbereich (15, 25) von einem sich nach außen verbreiternden Spalt umgeben ist, wobei die hydrophoben Oberflächen (16) der Leiterbahnen (12) und die hydrophoben Oberflächen (26) der Kontaktelemente (22) die Spaltflächen bilden.

6. Elektrisches Bauteil (10), insbesondere für eine elektrische Verbindungsanordnung gemäß den Ansprüchen 1 bis 5,
- welches einen flexiblen Träger (11) mit mehreren Leiterbahnen (12) aufweist,
- wobei zumindest in einem Anschlussbereich (13) die Enden (14) der Leiterbahnen (12) freigelegt sind und jeweils Kontaktflächen bilden, **dadurch gekennzeichnet, dass**
- die Enden (14) der Leiterbahnen (12) durch Schlitze (111) im flexiblen Träger (11) frei beweglich sind, wobei die Schlitze (111) die Enden der Leiterbahnen (12) u-förmig umgeben,
- wobei der flexible Träger (11) im Anschlussbereich (13) umgebogen ist, so dass sich die freigelegten Kontaktflächen der Leiterbahnen (12) auf der Unterseite befinden und auf der gegenüberliegenden Oberseite des flexiblen Trägers (11) die Enden (14) der Leiterbahnen (12) mit einer federnden Stützlage (17) versehen sind.

7. Elektrisches Bauteil nach Anspruch 6, **dadurch gekennzeichnet, dass** zur flüssigkeitsdichten Abdichtung die freien Enden (14) der Leiterbahnen (12) mit hydrophoben Oberflächen (16) versehen sind, so dass ein möglicher Kontaktbereich (15) vollständig von der hydrophoben Oberfläche (16) umschlossen ist.

8. Elektrisches Bauteil nach Anspruch 6 oder 7, **dadurch gekennzeichnet, dass** die federnde Stützlage (17) ein metallisches Federblatt ist, welches zu den Schlitzen (111) des flexiblen Träger (11) passende Schlitze (171) besitzt.

9. Elektrisches Bauteil nach Anspruch 6 oder 7, **dadurch gekennzeichnet, dass** die federnde Stützlage (17) durch 3D-Druck erzeugt wurde.

10. Steckerbauteil (20), insbesondere für eine elektrische Verbindungsanordnung gemäß den Ansprüchen 1 bis 5,
welcher eine Anzahl von Kontaktelemente (22) besitzt, die jeweils in einem Steckgehäuse (21) aufgenommen und mit elektrischen Leitungen (23) verbunden sind,
**dadurch gekennzeichnet, dass**
- zur flüssigkeitsdichten Abdichtung die Kontaktelemente (22) mit hydrophoben Oberflächen (26) versehen sind, so dass ein möglicher Kontaktbereich (25) vollständig von hydrophoben Oberflächen (26) umschlossen ist.

11. Steckerbauteil nach Anspruch 10, **dadurch gekennzeichnet, dass** der Kontaktbereich (25) der Kontaktelemente (22) jeweils durch ein Kontaktteil (24) gebildet ist, welches die umgebende Oberfläche der Kontaktelemente (22) überragt.

12. Steckerbauteil nach Anspruch 10 oder 11, **dadurch gekennzeichnet, dass** die Kontaktelemente (22) als flache Leiterbahnen auf einem flexiblen Träger vorgesehen sind und das jeweils die Oberfläche der Leiterbahnen überragende Kontaktteil (24) durch Prägung erzeugt wurde.

13. Steckerbauteil nach Anspruch 10 oder 11, **dadurch gekennzeichnet, dass** die Kontaktelemente (22) durch Leiterstränge eines Flachbandkabels gebildet sind, wobei die von der Isolierschicht freigelegten Leiterstränge so geformt sind, dass sie im Kontaktbereich (25) vorstehende Kontaktteile (24) zeigen.
